# EUROPEAN PATENT APPLICATION

(11) **EP 2 022 869 A2**
(43) Date of publication of application: **11.02.2009**
(21) Application number: 08252562.7
(22) Date of filing: 28.07.2008
(51) Int. Cl.: C23C 10/48, C23C 10/60, C23C 14/32

(54) **Method for forming active-element aluminide diffusion coatings**

(30) Priority: 02.08.2007 US 888820
(71) Applicant: United Technologies Corporation, Hartford, CT 06101 (US)
(72) Inventor: Minor, Michael J., Arlington, TX 76018 (US)
(74) Representative: Tomlinson, Kerry John

(57) **Abstract**

A method for forming a coating (14; 40) on a substrate (12; 38), the method comprising forming an active element coating (18; 44) over the substrate (12; 38) with a cathodic arc deposition process, and performing a diffusion coating process on at least the active element coating (18; 44) with an aluminum-based compound and a halide activator.

## Description

### BACKGROUND

The present invention relates to methods for coating metal components, such as aerospace components. In particular, the present invention relates to methods for forming active-element aluminide diffusion coatings that provide corrosion and oxidation resistance.

A gas turbine engine typically consists of an inlet, a compressor, a combustor, a turbine, and an exhaust duct. The compressor draws in ambient air and increases its temperature and pressure. Fuel is added to the compressed air in the combustor, where it is burned to raise gas temperature, thereby imparting energy to the gas stream. To increase gas turbine engine efficiency, it is desirable to increase the temperature of the gas entering the turbine. This requires the first stage turbine vanes and rotor blades to be able to withstand the thermal and oxidation conditions of the high temperature combustion gas during the course of operation.

To protect the first stage turbine vanes and rotor blades from the extreme conditions, such components typically include coatings (e.g., aluminide and/or platinum aluminide coatings) that provide oxidation and corrosion resistance. Such coatings may also contain active elements (e.g., MCrAlY coatings) to further increase corrosion and oxidation resistances. Active-element coatings are typically deposited through chemical vapor deposition (CVD) processes or plasma spraying processes. CVD processes typically involve depositing coatings with CVD generators through a chlorine gas. The deposition chemistry of CVD processes, however, are difficult to control, thereby increasing the complexity of the coating formation.

Plasma spraying processes (e.g., low-pressure plasma spraying) typically involve generating plasma jets, which melt and propel the desired materials toward desired substrates. However, the coating thicknesses of plasma sprayed coatings are difficult to control (e.g., variations up to about 50 micrometers (about 2 mils)). As such, the deposited coatings require coatings of sufficient thicknesses to ensure suitable concentrations of the active elements are deposited. The thick coatings, however, reduce the fatigue properties of the coatings (e.g., low-cycle fatigue), thereby rendering the coatings more susceptible to mechanical degradation. Accordingly, there is a need for a method for forming active-element aluminide coatings having low coating thicknesses for providing good fatigue properties.

### SUMMARY

The present invention relates to a method for forming an active-element aluminide coating on a substrate. The method includes forming an active element subcoating with a cathodic arc deposition process, and performing a diffusion coating process on at least the active element subcoating with an aluminum-based compound and a halide activator.

### BRIEF DESCRIPTION OF THE DRAWINGS

FIG. 1 is a sectional view of a metal component containing an active element, aluminide diffusion coating disposed on a substrate.
FIG. 2 is a flow diagram of a method for forming the active element, aluminide diffusion coating disposed on the substrate.
FIG. 3 is a sectional view of a metal component containing an active element, platinum aluminide diffusion coating disposed on a substrate.
FIG. 4 is a flow diagram of a method for forming the active element, platinum aluminide diffusion coating disposed on the substrate.

### DETAILED DESCRIPTION

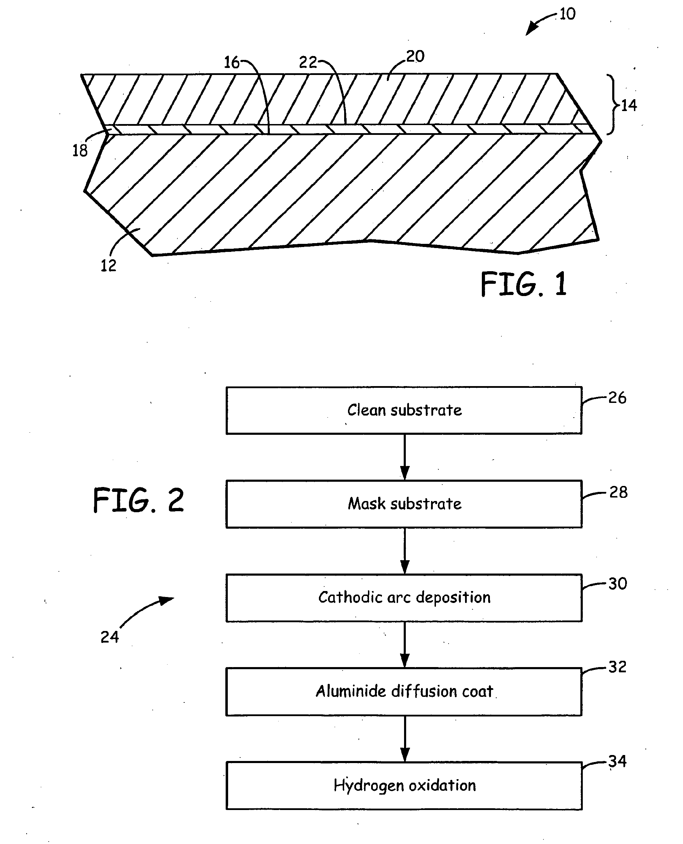

FIG. 1 is a sectional view of metal component 10, which includes substrate 12 and coating 14. Metal component 10 may be any type of component capable of containing coating 14, such as turbine engine components. Substrate 12 is a metal substrate of metal component 10, and includes surface 16. Examples of suitable materials for substrate 12 include nickel, nickel-based alloys and superalloys, cobalt, cobalt-based alloys and superalloys, and combinations thereof; and may also include one or more additional materials such as carbon, titanium, chromium, niobium, hafnium, tantalum, molybdenum, tungsten, aluminum, and iron. Surface 16 illustrates the original surface of substrate 12 before coating 14 is formed.

Coating 14 is a protective coating formed from subcoatings 18 and 20, pursuant to the present invention. Subcoating 18 is an active-element coating formed on surface 16 of substrate 12 with a cathodic arc deposition process. As discussed below, the cathodic arc deposition process allows subcoating 18 to be formed with low coating thicknesses. This improves the fatigue properties of metal component 10, while also providing a suitable concentration of active elements for corrosion and oxidation resistance. Examples of suitable active elements for subcoating 18 include elements that provide corrosion and/or oxidation resistance, such as yttrium, cerium, lanthanum, magnesium, hafnium, and silicon. Subcoating 18 includes at least one of the suitable active elements, and preferably includes more than one of the suitable active elements. Subcoating 18 may also include base materials such as nickel, cobalt, iron, platinum, chromium, aluminum, and combinations thereof. One or more of the base materials may be provided in subcoating 18 from the cathodic arc deposition process, from substrate 12 during a diffusion process, from subcoating 20 during a diffusion process, and combinations thereof. Subcoating 18 includes surface 22, which illustrates the original surface of subcoating 18 before subcoating 20 is formed.

Subcoating 20 is an aluminide diffusion coating interdiffused with substrate 12 and subcoating 18. Due to the interdiffusion between substrate 12 and subcoatings 18 and 20, the materials of substrate 12 and subcoatings 18 and 20 form one or more alloy gradients at surfaces 16 and 22. This effectively eliminates actual surfaces between substrate 12 and coating 14, and between subcoatings 18 and 20. Accordingly, the composition of coating 14 includes the materials from substrate 12 (e.g., nickel), the active elements (and any base materials) from subcoating 18, and aluminum from subcoating 20. An example of a suitable composition for coating 14 includes nickel, cobalt, chromium, aluminum, yttrium, hafnium, and silicon.

FIG. 2 is a flow diagram of method 24 for forming coating 14 on substrate 12 at surface 16. Method 24 includes steps 26-34, and initially involves cleaning surface 16 of substrate 12 (step 26). In one embodiment, coating 14 is substantially free of sulfur. As discussed in the above-listed, co-pending applications, sulfur impurities in aluminide coatings are known to reduce the oxidation resistances of the given coatings. Accordingly, surface 16 is desirably cleaned to remove any potential impurities (e.g., sulfur) located on surface 16. Examples of suitable cleaning techniques for step 26 include fluoride-ion treatments with hydrogen fluoride gas.

One or more portions of surface 16 may then be masked to prevent the formation of coating 14 over the masked portions of surface 16 (step 28). The masking process may be performed in a variety of manners, such as with condensation-curable maskants. In one embodiment, one or more portions of substrate 12 are masked with a composition disclosed in EP 1935928 entitled "Photocurable Maskant Composition and Method of Use".

Substrate 12 is then subjected to a cathodic arc deposition process to form subcoating 18, containing one or more active elements, on surface 16 of substrate 12 (step 30). In one embodiment, the cathodic arc coating process involves placing substrate 12 in a chamber containing a source of the active element(s) (e.g., a source ingot). Examples of suitable active elements for use in the cathodic arc deposition process include elements that provide corrosion and/or oxidation resistance, such as those discussed above for subcoating 18. The active element source may also include the above-discussed base materials for subcoating 18. The chamber is then purged of ambient air (e.g., down to about 1 x 10⁻⁶ Torr (1.33 x 10⁻⁴ Pa) or less), and backfilled with a gas to a sub-atmospheric pressure (e.g., about 500 Torr (6.67 x 10⁴ Pa) or less). Examples of suitable gases for backfilling the chamber include argon, hydrogen, and combinations thereof. A magnetic field is then generated around the active element source, which correspondingly generates a cathodic arc.

The cathodic arc vaporizes at least a portion of the active element source, thereby providing ions of the active element(s). The ionized active element(s) then deposit on surface 16 of substrate 12 to form subcoating 18. The cathodic arc deposition process is continued until a desired coating thickness is reached. The magnetic field is then removed, which correspondingly removes the cathodic arc. In contrast to plasma spraying processes, the cathodic arc deposition process provides good control of the deposition rate and uniformity. This allows subcoating 18 to be formed with a substantially uniform coating thickness. Suitable variations in the coating thickness for subcoating 18 formed with the cathodic arc deposition process of step 30 include about 13 micrometers (about 0.5 mils) or less, with particularly suitable coating thickness variations of about 2.5 micrometers (about 0.1 mils) or less. As such, subcoating 18 may be formed with a low coating thickness while retaining suitable concentrations of active element(s) for corrosion and oxidation resistance.

Examples of suitable coating thicknesses for subcoating 18 range from about 13 micrometers (about 0.5 mils) to about 76 micrometers (about 3 mils), with particularly suitable coating thicknesses ranging from about 13 micrometers (about 0.5 mils) to about 38 micrometers (about 1.5 mils). As discussed above, fatigue properties of a coating (e.g., low-cycle fatigue) are tied to the thickness of the coating. Accordingly, the low coating thicknesses obtainable with the cathodic arc deposition process allow subcoating 18 (and ultimately coating 14) to exhibit good fatigue properties, thereby reducing the susceptibility of coating 14 to mechanical degradation.

In the embodiment in which coating 14 is substantially free of sulfur, at least one of the active element source and the chamber gas used in the cathodic arc deposition process desirably has a low concentration of sulfur, or more preferably, is free of sulfur. Preferably, both the active element source and the chamber gas used in the cathodic arc deposition process have low concentrations of sulfur, or are free of sulfur. Examples of suitable concentrations of sulfur in each of the active element source and the chamber gas include less than about 20 ppm by weight, with particularly suitable concentrations of sulfur including less than about 10 ppm by weight, and with even more particularly suitable concentrations of sulfur including less than about 5 ppm by weight. This reduces sulfur contamination in the resulting coating 14, thereby enhancing the oxidation resistance of coating 14.

After the cathodic arc deposition process, substrate 12 and subcoating 18 are then subjected to an aluminide diffusion coating process, which desirably involves a pack cementation process (step 32). In one embodiment, the diffusion coating process involves placing substrate 12/subcoating 18 in a container (e.g., a retort) containing a powder mixture. The powder mixture includes an aluminum-based compound and a halide activator. In the embodiment in which coating 14 is substantially free of sulfur, at least one of the aluminum-based compound and the halide activator has a low concentration of sulfur, or more preferably, is free of sulfur. Preferably, both the aluminum-based compound and a halide activator desirably have low concentrations of sulfur, or are free of sulfur. Examples of suitable concentrations of sulfur in each of the aluminum-based compound and the halide activator include less than about 20 ppm by weight, with particularly suitable concentrations of sulfur including less than about 10 ppm by weight, and with even more particularly suitable concentrations of sulfur including less than about 5 ppm by weight. The low concentrations or lack of sulfur in the aluminum-based compound and the halide activator allow the resulting coating 14 to be substantially free of sulfur, thereby further enhancing the oxidation resistance of coating 14.

The aluminum-based compound is a material that includes aluminum, and may be an aluminum-intermetallic compound. Examples of suitable aluminum-intermetallic compound for use in the diffusion coating process include chromium-aluminum (CrAl) alloys, cobalt-aluminum (CoAl) alloys, chromium-cobalt-aluminum (CrCoAl) alloys, and combinations thereof. Examples of suitable concentrations of the aluminum-based compound in the powder mixture range from about 1% by weight to about 40% by weight.

The halide activator is a compound capable of reacting with the aluminum-based compound during the diffusion coating process. Examples of suitable halide activators for use in the diffusion coating process include aluminum fluoride (AIF₃), ammonium fluoride (NH₄F), ammonium chloride (NH₄Cl), and combinations thereof. Examples of suitable concentrations of the halide activator in the powder mixture range from about 1% by weight to about 50% by weight.

The powder mixture may also include inert materials, such as aluminum oxide. The container may also include one or more gases (e.g., H₂ and argon) to obtain a desired pressure and reaction concentration during the diffusion coating process. The one or more gases are desirably clean gases (i.e., low concentrations of impurities) to reduce the risk of contaminating coating 14 during formation. In one embodiment, the one or more gases have a low combined concentration of sulfur, or more preferably, are free of sulfur. Examples of suitable concentrations of sulfur in the one or more gases include the concentrations discussed above for the aluminum-based compound and the halide activator. The use of clean gases, such as clean hydrogen, further cleans coating 14 during the diffusion coating process, thereby further reducing the concentration of sulfur in coating 14.

After substrate 12/subcoating 18 are placed in the container and packed in a bed of the powder mixture, the container is sealed to prevent the reactants from escaping the container during the diffusion coating process. The container is then heated (e.g., in a furnace), which heats substrate 12, the aluminum-based compounds, the halide activators, and any additional materials in the container. The increased temperature initiates a reaction between the aluminum-based compounds and the halide activators to form gaseous aluminum-halide compounds. Suitable temperatures for initiating the reaction include temperatures ranging from about 650°C (about 1200°F) to about 1060°C (about 2000°F). The gaseous aluminum-halide compounds decompose at surface 22 of subcoating 18, thereby depositing aluminum on surface 22 to form coating 20. The deposition of the aluminum correspondingly release$ the halide activator to form additional gaseous aluminum-halide compounds while the aluminum-based compounds are still available.

Due to the elevated temperature, the deposited aluminum is in a molten or partially molten state. This allows the aluminum to dissolve the active element(s) of subcoating 18 at surface 22, thereby causing the material of substrate 12, the active element(s) of subcoating 18, and at least a portion of the aluminum to interdiffuse to form coating 14. The diffusion coating process is continued until a desired thickness of coating 14 is formed on substrate 12. Suitable thicknesses for providing corrosion and oxidation resistance to substrate 12 range from about 25 micrometers to about 125 micrometers, with particularly suitable thicknesses ranging from about 25 micrometers to about 75 micrometers. The thicknesses of coating 14 are measured from the location of surface 16 prior to the diffusion coating process. The diffusion coating process of step 32 may be discontinued by limiting the amount of aluminum-based compounds that are available to react with the halide activators, by reducing the temperature below the reaction-initiation temperature, or by a combination thereof. The resulting coating 14 is interdiffused into substrate 12 at surface 16, thereby allowing coating 14 to protect substrate 12 from corrosion and oxidation during use.

The interdiffusion causes a substantial portion of coating 14 to include the material of substrate 12, in addition to the active element(s) of subcoating 18 and the aluminum of subcoating 20. With respect to the embodiment in which coating 14 is substantially free of sulfur, because one or both of the aluminum-based compounds and the halide activators contained low concentrations of sulfur (or were free of sulfur), coating 14 has a reduced concentration of sulfur, thereby enhancing the oxidation resistance of coating 14. As discussed above, the concentration of sulfur may be further reduced with the use of an active element source and chamber gas in the cathodic arc deposition process that also contain low concentrations of sulfur (or are free of sulfur). This allows metal component 10 to exhibit greater resistance against oxidization-causing conditions, such as those that occur during the course of operating gas turbine engines.

To further enhance the oxidation resistance of coating 14, metal component 10 may subsequently undergo one or more hydrogen oxidation cycles to grow an oxide scale on coating 14 (step 34). Each hydrogen oxidation cycle involves heating metal component 10 in a dry hydrogen/oxygen atmosphere for a duration that is suitable for growing the oxide scale. Examples of suitable durations for each hydrogen oxidation cycle ranges from about 1 hour to about 5 hours. Examples of suitable temperatures for the hydrogen oxidation cycles range from about 900°C to about 1000°C. The hydrogen used in the hydrogen oxidation cycles is beneficial for further cleaning coating 14, thereby further removing any potential impurities, and allows a substantially pure oxide scale to be grown.

After coating 14 is formed, metal component 10 may then undergo additional process steps. For example, a thermal-barrier coating may be deposited onto coating 14 to protect coating 14 and substrate 12 from extreme temperatures. Suitable thermal-barrier coatings include ceramic-based layers formed on coating 14 with standard deposition techniques (e.g., physical vapor deposition and plasma spray techniques). The composition of coating 14 is particularly suitable for functioning as a bonding surface for the thermal-barrier coating, particularly with the formation of an oxide scale. Thus, in addition to providing corrosion and oxidation protection, coating 14 formed pursuant to the present invention is also suitable for functioning as a bond layer for a thermal-barrier coating.

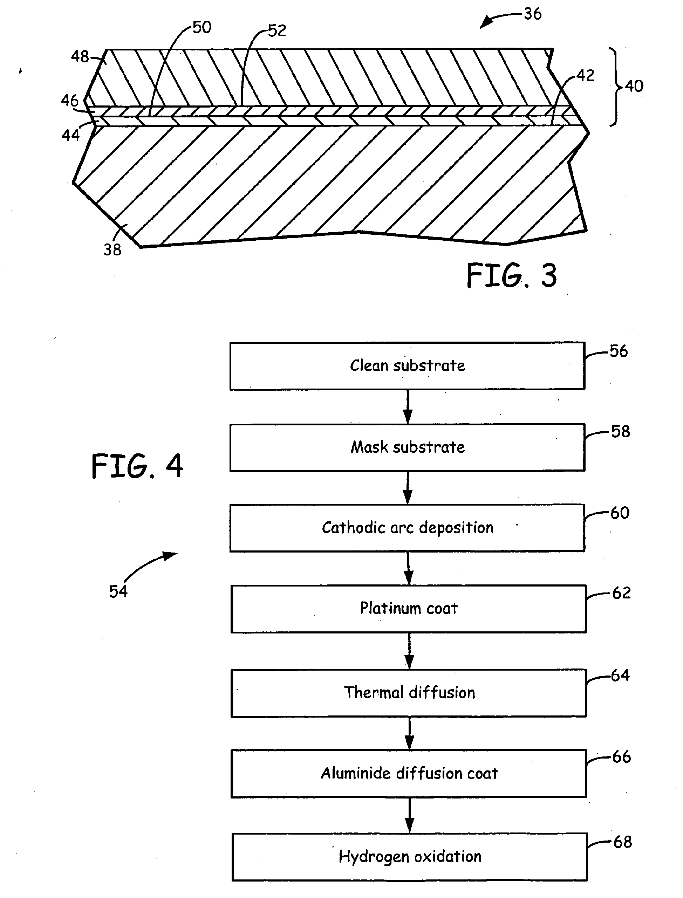

FIG. 3 is a sectional view of metal component 36, which includes substrate 38 and coating 40. Metal component 36 is similar to metal component 10 (shown in FIG. 1) and further includes diffused platinum. Substrate 38 is a metal substrate of metal component 36, and includes surface 42, where surface 42 illustrates the original surface of substrate 38 before coating 40 is formed. Examples of suitable materials for substrate 38 include those discussed above for substrate 12 (shown in FIG. 1).

Coating 40 is a protective coating formed from subcoatings 44, 46, and 48, pursuant to the present invention. Subcoating 44 is an active element coating formed on surface 42 of substrate 38 with a cathodic arc deposition process in the same manner as discussed above for subcoating 18 (shown in FIG. 1). Subcoating 44 includes surface 50, which illustrates the original surface of subcoating 44 before subcoating 46 is formed. Subcoating 46 is a platinum-based coating interdiffused with substrate 12 and subcoating 44, and includes surface 52. Surface 52 illustrates the original surface of subcoating 46 before subcoating 48 is formed.

Subcoating 48 is an aluminide diffusion coating interdiffused with substrate 38 and subcoatings 44 and 46. Due to the interdiffusion between substrate 38 and subcoatings 44, 46, and 48, the materials of substrate 38 and subcoatings 44, 46, and 48 form one or more alloy gradients at surfaces 42, 50, and 52. This effectively eliminates actual surfaces between substrate 38 and coating 40, and between subcoatings 44, 46, and 48. Accordingly, the composition of coating 40 includes the materials from substrate 38 (e.g., nickel), the active elements (and any base materials) from subcoating 44, platinum from subcoating 46, and aluminum from subcoating 48. An example of a suitable composition for coating 40 includes nickel, cobalt, chromium, platinum, aluminum, yttrium, hafnium, and silicon.

FIG. 4 is a flow diagram of method 54 for forming coating 40 on substrate 38, which is similar to method 24 (shown in FIG. 2) and further includes a platinum coating process. Method 54 includes steps 56-68, and initially involves cleaning surface 42 (step 56) and masking one or more portions of surface 42 (step 58). Suitable techniques for steps 56 and 58 include those discussed above for steps 26 and 28 of method 24.

Substrate 38 is then subjected to a cathodic arc deposition process to form subcoating 42, containing one or more active elements, on surface 42 of substrate 38 (step 60). Suitable techniques for the cathodic arc deposition process include those discussed above for step 30 of method 24. This forms subcoating 44 on surface 42 with a low variation in coating thicknesses. Suitable and particularly suitable variations in the coating thicknesses for subcoating 44 formed with the cathodic arc deposition process of step 60 include those discussed above for subcoating 18 (shown in FIG. 1). As such, subcoating 44 may be formed with a low coating thickness while retaining a suitable concentration of active element(s) for corrosion and oxidation resistance. Examples of suitable coating thicknesses for subcoating 44 include those discussed above for subcoating 18.

In one embodiment, coating 40 is substantially free of sulfur. In this embodiment, at least one of the active element source and the chamber gas used in the cathodic arc deposition process desirably has a low concentration of sulfur, or more preferably, is free of sulfur. Preferably, both the active element source and the chamber gas used in the cathodic arc deposition process have low concentrations of sulfur, or are free of sulfur. Examples of suitable concentrations of sulfur in each of the active element source and the chamber gas include those discussed above for the cathodic arc deposition process in step 30 of method 24 (shown in FIG. 2).

After subcoating 44 is formed with the cathodic arc deposition process, subcoating 44 is then platinum coated to form subcoating 46 (step 62). The platinum coating process is desirably performed with an electroplating process, which involves immersing substrate 38/subcoating 44 in a bath that contains a plating solution. Suitable plating solutions include solutions of platinum-salts in carrier fluids. As used herein, the term "solution" refers to any suspension of particles in a carrier fluid (e.g., water), such as dissolutions, dispersions, emulsions, and combinations thereof. In the embodiment in which coating 40 is substantially free of sulfur, the plating solution desirably has a low concentration of sulfur, or more preferably, is free of sulfur. Examples of suitable concentrations of sulfur in the plating solution include less than about 20 ppm by weight, with particularly suitable concentrations of sulfur including less than about 10 ppm by weight, and with even more particularly suitable concentrations of sulfur including less than about 5 ppm by weight. The low concentrations or lack of sulfur in the plating solution reduce the amount of sulfur present in the resulting coating 40, thereby enhancing the oxidation resistance of coating 40.

When substrate 38/subcoating 44 are immersed in the bath, a negative charge is placed on substrate 38/subcoating 44 and a positive charge is placed on the plating solution. The positive charge causes the platinum-salts of the plating solution to disassociate, thereby forming positive-charged platinum ions in the carrier fluid. The negative charge placed on substrate 38/subcoating 44 attracts the platinum ions toward surface 50 of subcoating 44, and reduces the positive charges on the platinum ions upon contact with subcoating 44. This forms subcoating 46 bonded to surface 50 of subcoating 44.

The electroplating process is performed for a duration, and with a plating current magnitude, sufficient to build subcoating 46 to a desired thickness on surface 50. Suitable thicknesses for subcoating 46 after step 62 of method 54 range from about 25 micrometers to about 500 micrometers, with particularly suitable thicknesses ranging from about 130 micrometers to about 250 micrometers, where the thicknesses of subcoating 46 are measured between surface 50 of subcoating 44 and surface 52 of subcoating 46. Examples of suitable processing conditions include a duration ranging from about one hour to about two hours at a plating current ranging from about 0.1 amperes to about 0.5 amperes. When subcoating 46 is formed, the negative and positive charges are removed from substrate 38/subcoating 44 and the plating solution, respectively, and substrate 38 (including subcoatings 44 and 46) is removed from the bath.

Substrate 38 and subcoatings 44 and 46 are then subjected to a thermal diffusion process to interdiffuse at least a portion of the active element(s) of subcoating 44 and at least a portion of the platinum of subcoating 46 with the material of substrate 38 (step 64). In one embodiment, the thermal diffusion process involves placing the combined substrate 38 and subcoatings 44 and 46 in a furnace and heating substrate 38/subcoatings 44 and 46 to a sufficient temperature and for a sufficient duration to obtain a desired level of interdiffusion. The thermal treatment process is desirably performed for a suitable duration to interdiffuse the platinum of subcoating 46 with the materials of substrate 38 and the active elements(s) of subcoating 44, thereby effectively forming one or more alloys gradients along surfaces 42 and 50. Examples of suitable temperatures for the thermal diffusion process include temperatures ranging from about 930°C (about 1700°F) to about 1090°C (about 2000°F), with particularly suitable temperatures ranging from about 1040°C (about 1900°F) to about 1080°C (about 1975°F). Examples of suitable durations include at least about one hour, with particularly suitable durations ranging from about two hours to about four hours.

Substrate 38 and subcoatings 44 and 46 are then subjected to an aluminide diffusion coating process (step 66). Suitable techniques, systems, and materials for the aluminide diffusion coating process of step 66 include those discussed above for step 32 of method 24. Accordingly, during the aluminide diffusion coating process, gaseous aluminum-halide compounds decompose at surface 52 of subcoating 46, thereby depositing aluminum on surface 52 to form subcoating 48. The deposited aluminum dissolves the material of subcoatings 44 and 46, thereby causing the material of substrate 38, the active element(s) of subcoating 44, the platinum of subcoating 46, and at least a portion of the aluminum to interdiffuse to form coating 40. Suitable thicknesses of coating 40 include those discussed above for coating 14 in step 32 of method 24 (shown in FIG. 2). The resulting coating 40 is interdiffused into substrate 38, thereby allowing coating 40 to protect substrate 38 from corrosion and oxidation during use.

The interdiffusion causes a substantial portion of coating 40 to include the material of substrate 38, in addition to the active element(s) of subcoating 44, the platinum of subcoating 46, and the aluminum of subcoating 48. In the embodiment in which coating 40 is substantially free of sulfur, because one or both of the aluminum-based compounds and the halide activators contained low concentrations of sulfur (or were free of sulfur), coating 40 has a reduced concentration of sulfur, thereby enhancing the oxidation resistance of coating 40.

Additionally, as discussed above, the concentration of sulfur may be further reduced with the use of an active element source and chamber gas in the cathodic arc deposition process that also contain low concentrations of sulfur (or are free of sulfur). Moreover, as discussed above, the concentration of sulfur may be even further reduced with the use of a plating solution that also contains a low concentration of sulfur (or is free of sulfur). The reduced-sulfur concentration allows metal component 36 to exhibit greater resistance against oxidization-causing conditions, such as those that occur during the course of operating gas turbine engines.

In an alternative embodiment, the thermal diffusion process of step 64 is omitted, and the interdiffusion of the material of substrate 38, the active element(s) of subcoating 44, and the platinum of subcoating 46 occurs during the aluminide diffusion coating process of step 66. In this embodiment, the interdiffusion of the aluminum of subcoating 48 causes the active element(s) of subcoating 44 and the platinum of subcoating 46 to also interdiffuse with the materials of substrate 38, thereby forming one or more alloy gradients along surfaces 42, 50, and 52.

In another alternative embodiment, the cathodic arc deposition process of step 60 and the platinum coating process of step 62 are transposed. In this embodiment, subcoating 46 is plated on surface 42 of substrate 38, and subcoating 44 is then formed on the surface of subcoating 46 with a cathodic arc deposition process. Because the active element(s) of subcoating 44 and the platinum of subcoating 46 are subsequently interdiffused with the material of substrate 38 in steps 64 and 66, subcoating 44 may be deposited before or after subcoating 46.

To further enhance the oxidation resistance of coating 40, metal component 36 may subsequently undergo one or more hydrogen oxidation cycles to grow an oxide scale on coating 40 (step 68). Suitable techniques for the hydrogen oxidation cycles include those discussed above for step 34 of method 24. After coating 40 is formed, metal component 36 may then undergo additional process steps, as discussed above for metal component 10. Accordingly, pursuant to the present invention, metal component substrates may be coated with protective coatings containing one or more active elements, platinum, and aluminum to provide corrosion and oxidation resistance.

Although the present invention has been described with reference to preferred embodiments, workers skilled in the art will recognize that changes may be made in form and detail without departing from the scope of the invention, which is defined by the claims and their equivalents.

## Claims

1. A method for forming a coating (14; 40) on a substrate (12; 38) , the method comprising:
forming an active element coating (18; 44) over the substrate with a cathodic arc deposition process, wherein the active element coating (18; 44) comprises at least one active element selected from the group consisting of yttrium, cerium, lanthanum, magnesium, hafnium, and silicon; and
performing a diffusion coating process on at least the active element coating (18; 44) with an aluminum-based compound and a halide activator.

2. The method of claim 1, wherein the active element coating (18; 44) has a variation in coating thickness that is about 13 micrometers or less.

3. The method of claim 2, wherein the variation in coating thickness is about 2.5 micrometers or less.

4. The method of any preceding claim, further comprising forming a platinum-containing coating (46) on the active element coating (44).

5. The method of claim 1, 2 or 3 further comprising forming a platinum-containing coating (46) on the substrate, wherein the active element coating (44) is formed on the platinum-containing coating (46).

6. The method of claim 1, wherein the active-element coating is an active-element aluminide coating and the method further comprises exposing the active-element aluminide coating (18; 44) to at least one hydrogen oxidation cycle.

7. The method of any preceding claim, wherein the cathodic arc deposition process is performed with an active element source and a chamber gas, and wherein at least one of the active element source and the chamber gas has a sulfur concentration of less than about 20 parts-per-million by weight.

8. The method of any preceding claim, wherein at least one of the aluminum-based compound and the halide activator has a sulfur concentration of less than about 20 parts-per-million by weight.

9. The method of any preceding claim, wherein the coating thickness of the active element coating ranges from about 13 micrometers to about 76 micrometers.

10. The method of claim 9, wherein the coating thickness of the active element coating ranges from about 13 to about 38 micrometers.
